# EUROPÄISCHE PATENTSCHRIFT

(11) **EP 3 804 467 B1**
(45) Veröffentlichungstag und Bekanntmachung des Hinweises auf die Patenterteilung: **31.07.2024**
(21) Anmeldenummer: 19728431.8
(22) Anmeldetag: 04.06.2019
(51) Int. Cl.: H05B 45/375

(54) **AUTOMATISCHES KALIBRIEREN EINER STROMMESSVORRICHTUNG**
AUTOMATIC CALIBRATION OF A CURRENT MEASURING DEVICE
ÉTALONNAGE AUTOMATIQUE D'UN DISPOSITIF DE MESURE DE COURANT

(30) Priorität: 07.06.2018 DE 102018209077
(43) Veröffentlichungstag der Anmeldung: 14.04.2021
(73) Patentinhaber: Tridonic GmbH & Co. KG, 6851 Dornbirn (AT)
(72) Erfinder: GSTIR, Sascha, 6923 Lauterach (AT); KUCERA, Clemens, 6700 Bludenz (AT); LOCHMANN, Frank, 88147 Achberg (DE); MARTE, Patrick, 6840 Götzis (AT); MAYRHOFER, Markus, 6850 Dornbirn (AT); NESENSOHN, Christian, 6840 Götzis (AT); NETZER, Harald, 6710 Nenzing (AT); WYNNYCZENKO, Oliver, 6890 Lustenau (AT); REIMONDEZ, David, 6850 Dornbirn (AT)
(74) Vertreter: Kraus & Lederer PartGmbB
(86) Internationale Anmeldenummer: PCT/EP2019/064452
(87) Internationale Veröffentlichungsnummer: WO 2019/233996

(56) Entgegenhaltungen:
- WO-A1-2005/022957
- US-A1- 2006 226 898
- US-A1- 2013 076 252

## Beschreibung

### TECHNISCHES GEBIET

Die vorliegende Erfindung betrifft ein Verfahren zum Kalibrieren einer Strommessvorrichtung einer Steuervorrichtung für ein Leuchtmittel sowie eine Strommessvorrichtung, welche das Verfahren verwendet. Die vorliegende Erfindung betrifft insbesondere ein Kalibrieren einer Strommessvorrichtung einer Steuervorrichtung für LED-Leuchtmittel.

### HINTERGRUND DER ERFINDUNG

Zum Betreiben von Leuchtmitteln, welche beispielsweise auf Leuchtdioden (LED) basieren, werden typischerweise Schaltungsanordnungen verwendet, welche aus einer Netzspannung oder Versorgungsspannung, wie zum Beispiel einer Wechselspannung oder Gleichspannung im Bereich von 120-240 V, eine für den Betrieb der Leuchtmittel geeignete Spannung und/oder einen für den Betrieb der Leuchtmittel geeigneten Strom erzeugen. Im Zusammenhang mit LED-Leuchtmitteln wird eine derartige Schaltungsanordnung häufig als LED-Wandler, LED-Konverter oder LED-Steuervorrichtung bezeichnet. Beispielsweise können derartige Schaltungsanordnungen Abwärtswandler umfassen, bei welchen eine gewünschte Ausgangsspannung oder ein gewünschter Ausgangsstrom über ein Tastverhältnis eines Schaltmittels in dem Abwärtswandler eingestellt werden kann. Ferner kann es wünschenswert sein, die Helligkeit des LED-Leuchtmittels einzustellen. Eine derartige Einstellung wird auch als "Dimmen" bezeichnet. Ein derartiges Dimmen kann bei Verwendung eines Abwärtswandlers ebenfalls über das Tastverhältnis des Schaltmittels eingestellt werden.

Zum Einstellen eines gewünschten Stroms durch das Leuchtmittel kann ein Regelungsverfahren verwendet werden. Bei dem Regelungsverfahren kann beispielsweise ein aktuell durch das Leuchtmittel fließender Strom gemessen werden und mit einem gewünschten Sollstrom verglichen werden. In Abhängigkeit von dem Vergleich des aktuell durch das Leuchtmittel fließenden Stroms mit dem Sollstrom kann die LED-Steuervorrichtung den aktuell durch das Leuchtmittel fließenden Strom an den Sollstrom durch beispielsweise geeignetes Ansteuern des Abwärtswandlers angleichen. Beispielsweise kann das Tastverhältnis des Schaltmittels in Abhängigkeit von dem Vergleich verändert werden. Für eine genaue Einstellung des gewünschten Stroms durch das Leuchtmittel ist daher eine genaue Messung des durch das Leuchtmittel fließenden Stroms erforderlich. Übliche Schaltungen zur Strommessung können jedoch Ungenauigkeiten aufweisen, welche beispielsweise bei der Fertigung der Schaltung durch Toleranzen der Bauteile oder im Betrieb der Schaltung durch Alterung und Temperaturänderung bedingt sein können.

Die US 2006/0226898 A1 betrifft einen Offset-Korrekturschaltkreis für eine spannungsgesteuerte Stromquelle für eine LED. Ein Transkonduktanzverstärker dient als Fehlerverstärker in einer Regelschleife. Der invertierende Eingang des Transkonduktanzverstärkers ist mit der Katode der LED und über einen Widerstand mit Masse gekoppelt. In einer Normalbetriebsart ist ein Schalter geöffnet, um die Eingänge des Transkonduktanzverstärker zu trennen. In einer Offset-Korrekturbetriebsart ist der Schalter geschlossen, um den nicht-invertierenden Eingang des Transkonduktanzverstärkers mit dem invertierenden Eingang zu koppeln. Für die Offset-Korrektur dient die Ausgangsspannung des Transkonduktanzverstärker bei kurzgeschlossenen Eingängen.

Aufgabe der vorliegenden Erfindung ist es daher, die Genauigkeit einer Strommessung in einer Steuervorrichtung für ein Leuchtmittel zu verbessern.

### ZUSAMMENFASSUNG DER ERFINDUNG

Diese Aufgabe wird gemäß der vorliegenden Erfindung durch ein Verfahren zum Kalibrieren einer Strommessvorrichtung einer Steuervorrichtung für ein Leuchtmittel sowie eine Strommessvorrichtung für eine Steuervorrichtung für ein Leuchtmittel gemäß der unabhängigen Ansprüche gelöst. Die abhängigen Ansprüche definieren Ausführungsformen der Erfindung.

Gemäß einem Ausführungsbeispiel wird ein Verfahren zum Kalibrieren einer Strommessvorrichtung einer Steuervorrichtung für ein Leuchtmittel bereitgestellt. Die Strommessvorrichtung umfasst Messmittel, welche im Betrieb der Steuervorrichtung mit dem Leuchtmittel gekoppelt sind. Das Leuchtmittel kann beispielsweise eine Leuchtdiode (LED) umfassen. Bei dem Verfahren wird automatisch ein vorgegebener Strom durch die Messmittel im Betrieb der Steuervorrichtung eingestellt. Während der vorgegebene Strom durch die Messmittel eingestellt ist, wird automatisch eine elektrische Größe an den Messmitteln erfasst. In Abhängigkeit von der erfassten elektrischen Größe wird ein Korrekturwert für die Strommessvorrichtung automatisch bestimmt.

Anders ausgedrückt wird im Betrieb der Steuervorrichtung ein definierter Strom durch die Messmittel geleitet und eine entsprechende elektrische Größe erfasst, auf deren Grundlage ein Korrekturwert für die Strommessvorrichtung bestimmt und eingestellt werden kann. Somit kann im Betrieb der Steuervorrichtung eine Kalibrierung der Strommessvorrichtung anhand des definierten Stroms durchgeführt werden. Dadurch ist es möglich, sowohl fertigungsbedingte Bauteiltoleranzen als auch durch Alterung oder Temperaturänderung bedingte Änderungen in der Strommessvorrichtung im Betrieb der Steuervorrichtung auszugleichen. Das Verfahren kann beispielsweise beim Einschalten oder Aktivieren der Steuervorrichtung sowie in regelmäßigen Abständen im Betrieb der Steuervorrichtung durchgeführt werden. Ferner kann das Verfahren durchgeführt werden, wenn signifikante Änderungen im Betrieb der Steuervorrichtung erfasst werden, beispielsweise eine Temperaturänderung oder eine Laständerung oder eine Änderung in der Versorgungsspannung der Steuervorrichtung.

Bei einem Ausführungsbeispiel kann der vorgegebene Strom durch die Messmittel im Betrieb der Steuervorrichtung eingestellt werden, indem ein Stromfluss durch die Messmittel im Betrieb der Steuervorrichtung verhindert wird. Dadurch kann beispielsweise als definierter Strom ein Strom der Größe Null durch die Messmittel im Betrieb der Steuervorrichtung eingestellt werden.

Beispielsweise kann ein erster Anschluss der Messmittel mit einem zweiten Anschluss der Messmittel mittels eines von der Strommessvorrichtung steuerbaren Schalters verbunden werden. Durch ein derartiges Kurzschließen der Messmittel kann beispielsweise ein definierter Strom der Größe Null durch die Messmittel erreicht werden.

Der Schalter kann beispielsweise einen Feldeffekttransistor umfassen. Alternativ kann der Schalter eine beliebige andere Art von einer elektronischen Schaltvorrichtung, beispielsweise einen am MOSFET oder einen bipolaren Transistor umfassen. Darüber hinaus kann der Schalter auch beispielsweise ein Relais, insbesondere ein Reed Relais umfassen.

Bei einer weiteren Ausführungsform kann die Steuervorrichtung eine Schaltvorrichtung zum Steuern eines Stroms durch das Leuchtmittel umfassen. Die Schaltvorrichtung kann beispielsweise ein Schaltmittel in einem Abwärtswandler der Steuervorrichtung sein. Zum Einstellen des vorgegebenen Stroms durch die Messmittel im Betrieb der Steuervorrichtung kann die Schaltvorrichtung während einer Startphase der Steuervorrichtung gesperrt werden, bis die elektrische Größe an dem Messmittel erfasst wurde. Anders ausgedrückt kann beispielsweise beim Aktivieren oder Einschalten der Steuervorrichtung die Strommessvorrichtung kalibriert werden solange noch kein Strom von der Steuervorrichtung für das Leuchtmittel bereitgestellt wird. Der vorgegebene Strom durch die Messmittel ist in diesem Fall ein Strom der Größe Null.

Die Messmittel umfassen einen Messwiderstand, welcher auch als Messshunt bezeichnet wird und durch welchen, wenn im Betrieb der Steuervorrichtung nicht der vorgegebene Strom durch die Messmittel eingestellt ist, der Strom durch den Messwiderstand zumindest im Mittel gleich dem Strom durch das Leuchtmittel ist.

Die Messmittel sind im Betrieb der Steuervorrichtung in Reihe mit dem Leuchtmittel geschaltet.

Die elektrische Größe wird als ein Spannungsabfall über den Messmitteln gemessen.

Anders ausgedrückt kann die Strommessvorrichtung eine Strommessung an einem Messwiderstand durchführen, welcher in Reihe zu dem Leuchtmittel geschaltet ist. Somit fließt ein Strom durch das Leuchtmittel auch durch den Messwiderstand. Die Strommessvorrichtung misst dann einen Spannungsabfall über dem Messwiderstand. Der Spannungsabfall über dem Messwiderstand ist proportional zu dem Strom durch den Messwiderstand bzw. das Leuchtmittel. Zum Abgleich der Strommessvorrichtung kann ein Strom der Größe Null durch den Messwiderstand eingestellt werden, beispielsweise indem der Abgleich der Strommessvorrichtung erfolgt, wenn während einer Startphase der Steuervorrichtung noch kein Strom durch das Leuchtmittel fließt, oder indem der Messwiderstand kurzgeschlossen wird. Der dann gemessene Spannungsabfall über dem Messwiderstand sollte ebenfalls Null sein. Abweichungen können durch Bauteiltoleranzen oder temperaturbedingt auftreten. Ein entsprechender Korrekturwert, welcher beispielsweise dem gemessenen Spannungsabfall beim Strom der Größe Null entspricht, kann in der Strommessvorrichtung gespeichert werden und bei nachfolgenden Messungen zur Korrektur des gemessenen Spannungsabfalls verwendet werden. Eine Umrechnung des gemessenen Spannungsabfalls bzw. des gemessenen und korrigierten Spannungsabfalls in einen entsprechenden Strom kann beispielsweise über einen Proportionalitätsfaktor oder eine Nachschlagetabelle (Look-up table) erfolgen.

Ein weiteres Ausführungsbeispiel betrifft eine Strommessvorrichtung für eine Steuervorrichtung für ein Leuchtmittel. Die Strommessvorrichtung umfasst Messmittel, eine Wandlerschaltung und eine Kalibriersteuerung. Die Messmittel sind im Betrieb der Steuervorrichtung mit dem Leuchtmittel gekoppelt. Die Wandlerschaltung ist mit den Messmitteln gekoppelt. Die Wandlerschaltung ist ausgestaltet, eine elektrische Größe an den Messmitteln zu erfassen. Die Kalibriersteuerung ist ausgestaltet, einen vorgegebenen Strom durch die Messmittel im Betrieb der Steuervorrichtung einzustellen. Ferner ist die Kalibriersteuerung ausgestaltet, mittels der Wandlerschaltung die elektrische Größe an den Messmitteln zu ermitteln, während der vorgegebene Strom eingestellt ist, und einen Korrekturwert für die Strommessvorrichtung in Abhängigkeit von der elektrischen Größe zu bestimmen.

Die Strommessvorrichtung ist somit zur Durchführung des zuvor beschriebenen Verfahrens oder einer seiner Ausführungsformen in der Lage und umfasst daher auch die zuvor im Zusammenhang mit dem Verfahren beschriebenen Vorteile.

Ein weiteres Ausführungsbeispiel betrifft eine Dimmschaltung für eine Leuchtdiode. Die Dimmschaltung umfasst die zuvor beschriebene Strommessvorrichtung. Insbesondere bei Dimmschaltungen für Leuchtdioden kann ein Strom durch die Leuchtdioden verhältnismäßig gering sein und daher ist eine genaue Regelung des Stroms durch die Leuchtdioden von Vorteil, um beispielsweise ein Flackern zu vermeiden. Durch das Kalibrieren der Strommessvorrichtung im Betrieb der Dimmschaltung kann ein genau gesteuerter, insbesondere flackerfreier Betrieb ermöglicht werden.

### KURZE BESCHREIBUNG DER FIGUREN

Die vorliegende Erfindung wird nachfolgend unter Bezugnahme auf die Figuren anhand von Ausführungsformen erläutert. In den Figuren bezeichnen identische Bezugszeichen identische Elemente.
Fig. 1 zeigt schematisch eine Steuervorrichtung gemäß einer Ausführungsform der vorliegenden Erfindung.
Fig. 2 zeigt schematisch Schritte eines Verfahrens gemäß einer Ausführungsform der vorliegenden Erfindung.
Fig. 3 zeigt schematisch Schritte eines Verfahrens gemäß einer weiteren Ausführungsform der vorliegenden Erfindung.
Fig. 4 zeigt schematisch eine Steuervorrichtung gemäß einer weiteren Ausführungsform der vorliegenden Erfindung.

### DETAILLIERTE BESCHREIBUNG VON AUSFÜHRUNGSBEISPIELEN

Die oben beschriebenen Eigenschaften, Merkmale und Vorteile dieser Erfindung sowie die Art und Weise, wie diese erreicht werden, werden nachfolgend unter Bezugnahme auf die Zeichnungen anhand von Ausführungsbeispielen im Detail erläutert werden.

Gleiche Bezugszeichen in den nachfolgenden Figuren bezeichnen im Wesentlichen gleiche Komponenten.

Die nachfolgend beschriebenen Ausführungsbeispiele beziehen sich auf Steuervorrichtungen zum Betreiben von LED-Leuchtmitteln, sind jedoch nicht darauf beschränkt, sondern können auch für andere Arten von Leuchtmitteln eingesetzt werden, beispielsweise Halogenleuchtmittel.

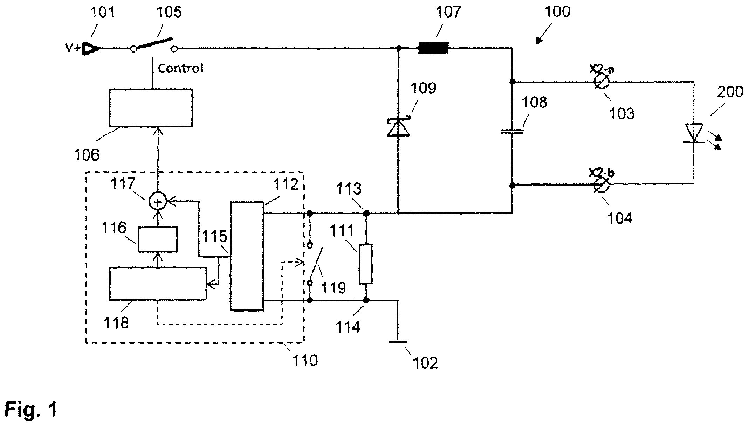

Fig. 1 zeigt eine Steuervorrichtung 100 zur Versorgung eines LED-Leuchtmittels 200. Die Steuervorrichtung 100 umfasst einen Eingang 101 zur Aufnahme einer Versorgungsspannung V+. Die Versorgungsspannung V+ kann ein Spannungspotenzial in Bezug auf ein Massepotenzial sein, welches der Steuervorrichtung 100 über einen Masseanschluss 102 zugeführt wird. Die Steuervorrichtung 100 weist ferner Ausgangsanschlüsse 103 (X2-a) und 104 (X2-b) auf, an welchen eine Ausgangsspannung zur Versorgung des daran angeschlossenen LED-Leuchtmittels 200 bereitgestellt wird. Mithilfe der Steuervorrichtung 100 kann aus der Versorgungsspannung V+ eine für das LED-Leuchtmittel 200 geeignete Ausgangsspannung sowie ein für das LED-Leuchtmittel 200 geeigneter Ausgangsstrom an den Ausgangsanschlüssen 103 und 104 erzeugt werden.

Die der Steuervorrichtung 100 zugeführte Versorgungsspannung V+ kann beispielsweise eine Gleichspannung im Bereich von etwa 10 V bis hin zu einigen 100 V umfassen, beispielsweise 12 V, 24 V 60V, 120V oder 230 V. Die Versorgungsspannung V+ kann beispielsweise mithilfe einer nicht gezeigten Eingangsstufe aus einer Netzspannung mit einem landestypischen Effektivwert von 230 V oder 120 V erzeugt werden. Die Ausgangsspannung zur Versorgung des LED-Leuchtmittels 200 kann beispielsweise wenige Volt betragen, beispielsweise 2 V oder im Bereich von 10 - 50 V liegen.

Zur Erzeugung der Ausgangsspannung an den Ausgangsanschlüssen 103 und 104 aus der Versorgungsspannung V+ kann die Steuervorrichtung 100 beispielsweise einen Abwärtswandler umfassen. Abwärtswandler werden auch Tiefsetzsteller oder Abwärtsregler genannt. Im Englischen werden Abwärtswandler als Step-down Converter oder Buck Converter bezeichnet.

Die Steuervorrichtung 100 umfasst einen Schalter 105, beispielsweise einen Transistor, welcher von einer Steuerung 106 über eine Steuerleitung (Control) regelmäßig ein- und ausgeschaltet wird. Üblicherweise können einige Hundert bis mehrere Millionen Schaltzyklen je Sekunde durchgeführt werden. Dadurch wird elektrische Energie von dem Eingang 101 zu den Ausgangsanschlüssen 103 und 104 transferiert. Dazu umfasst die Steuervorrichtung 100 ferner einen induktiven Energiespeicher 107, beispielsweise eine Spule, einen kapazitiven Energiespeicher 108, beispielsweise einen Kondensator, und eine Diode 109, welche auch als Freilaufdiode bezeichnet wird. Die beiden Energiespeicher Spule 107 und Kondensator 108 ermöglichen die Versorgung des Leuchtmittels 200 in den Phasen, in denen der Schalter 105 geöffnet ist. Die Induktivität der Spule 107 hält die höhere Versorgungsspannung V+ von dem Leuchtmittel 200 fern. Die Ausgangsspannung bzw. der Ausgangsstrom an den Ausgangsanschlüssen 103 und 104 kann durch Steuern der Ein- und Ausschaltzeiten des Schalters 105 eingestellt werden.

Während einer Einschaltzeit, in welcher der Schalter 105 geschlossen ist, fließt ein Strom durch die Spule 107 und durch das LED-Leuchtmittel 200. Während einer Ausschaltzeit, in welcher der Schalter 105 geöffnet ist, wird die in der Spule 107 gespeicherte Energie abgebaut und durch das LED-Leuchtmittel fließt weiterhin ein Strom. Die Diode 109 ist leitend und schließt somit den Stromkreis. Ferner fließt während der Ausschaltzeit ein Strom aus dem Kondensator 108 durch das LED-Leuchtmittel 200.

Beim Betrieb der Steuervorrichtung 100 als Abwärtswandler können zwei unterschiedliche Betriebsarten unterschieden werden: ein lückender Betrieb und ein nichtlückender Betrieb.

Im nichtlückenden Betrieb, welcher auch als kontinuierlicher Betrieb oder im Englischen als Continuous Current Mode (CCM) bezeichnet wird, fließt während des gesamten Zyklus immer Strom durch die Spule 107. Dies wird dadurch erreicht, dass der Schalter 105 bereits erneut geschlossen wird, bevor die gespeicherte Energie aus der Spule 107 vollständig abgebaut ist.

Im lückenden Betrieb, welcher auch als Lückbetrieb oder im Englischen als Discontinuous Current Mode (DCM) bezeichnet wird, sinkt der Strom durch die Spule 107 auf Null ab. Es ergibt sich somit eine dritte Phase in dem Schaltzyklus: Zusätzlich zu den auch im nichtlückenden Betrieb auftretenden Phasen der Energiespeicherung bei geschlossenem Schalter 105 und der Energiefreisetzung der Energie aus der Spule 107 bei geöffnetem Schalter 105 kommt die sogenannte Lückphase hinzu, in welcher kein Strom durch die Spule 107 fließt und das LED-Leuchtmittel ausschließlich mit Energie aus dem Kondensator 108 versorgt wird. Bei geschlossenem Schalter 105 wird der Kondensator 108 über die Spule 107 wieder aufgeladen.

Die Steuerung 106 kann die Ein- und Ausschaltzeiten des Schalters 105 mit einer Regelung einstellen, um einen Strom durch das Leuchtmittel 200 auf einen bestimmten gewünschten Wert zu regeln. Dazu kann die Steuerung 106 einen aktuell durch das Leuchtmittel 200 fließenden Strom mit einem gewünschten Sollwertstrom vergleichen und in Abhängigkeit von dem Vergleich die Ein- und Ausschaltzeiten des Schalters 105 einstellen.

Zum Messen des aktuell durch das Leuchtmittel 200 fließenden Stroms ist eine Strommessvorrichtung 110 vorgesehen. Die Strommessvorrichtung 110 umfasst einen Messwiderstand 111, welcher in Reihe zu dem Leuchtmittel 200 zwischen dem Leuchtmittel 200 und Masse 102 geschaltet ist, und eine Wandlerschaltung 112. Unabhängig von den oben beschriebenen Betriebsarten und Betriebsphasen fließt der gesamte durch das Leuchtmittel 200 fließende Strom auch durch den Messwiderstand 111, gegebenenfalls zeitlich versetzt, wenn das Leuchtmittel 200 nur mit Energie von dem Kondensator 108 versorgt wird, welcher zuvor aufgeladen wurde. Daher ist der durch den Messwiderstand 111 fließende Strom zumindest im Mittel gleich dem Strom durch das Leuchtmittel 200.

An dem Messwiderstand 111 entsteht ein Spannungsabfall, welcher von einer Wandlerschaltung 112 erfasst wird. Dazu ist die Wandlerschaltung 112 mit einem ersten Anschluss 113 und einem zweiten Anschluss 114 des Messwiderstandes 111 verbunden und misst eine Spannung zwischen dem ersten Anschluss 113 und dem zweiten Anschluss 114 als den Spannungsabfall. Aufgrund der weiter oben beschriebenen Betriebsphasen des Abwärtswandlers kann es erforderlich sein, den Spannungsabfall über dem Messwiderstand 111 über einen bestimmten Zeitraum hinweg zu mitteln, um einen Effektivwert des Spannungsabfalls bzw. des Stroms durch den Messwiderstand 111 zu bestimmen. Dieses Mitteln kann beispielsweise mit einer analogen Integrierschaltung mit einem gleitenden Mittelwertfenster oder digital durch mehrfaches Abtasten des Spannungsabfalls mit hoher Frequenz und anschließender Mittelung der abgetasteten Werte erreicht werden. An einem Ausgang 115 stellt die Wandlerschaltung 112 einen dem Spannungsabfall entsprechenden Ausgangswert zur Verfügung. Aufgrund der Strom-Spannungsbeziehung über dem Messwiderstand 111 entspricht dieser Ausgangswert einer Stromgröße durch den Messwiderstand 111.

Die Wandlerschaltung 112 kann analog ausgebildet sein und beispielsweise einen oder mehrere geeignet beschaltete Operationsverstärker umfassen, um beispielsweise das oben beschriebenen Mitteln zu realisieren und/oder einen verhältnismäßig kleinen Spannungsabfall über dem Messwiderstand 111 auf einen geeigneten weiterverarbeitbaren Wert zu verstärken. Alternativ oder zusätzlich kann die Wandlerschaltung 112 einen Digital-/Analogwandler und eine digitale Verarbeitungsvorrichtung umfassen, welche beispielsweise durch Mittelung mehrerer Abtastwerte von dem Digital-/Analogwandler den Ausgangswert bestimmt und am Ausgang 115 bereitstellt. Der Ausgangswert kann dementsprechend beispielsweise als ein analoger Spannungswert oder als ein digitaler Ausgangswert am Ausgang 115 bereitgestellt werden.

Unabhängig davon, ob die Wandlerschaltung 112 analog oder zumindest teilweise digital ausgebildet ist, kann die Umsetzung des Spannungsabfalls in den Ausgangswert Fehler oder Ungenauigkeiten aufweisen, welche sich aus Bauteiltoleranzen oder temperatur- oder alterungsbedingten Änderungen von Bauteileigenschaften ergeben. Daher umfasst die Strommessvorrichtung 110 einen Korrekturwertspeicher 116 und einen Addierer 117. Bevor der Ausgangswert von der Wandlerschaltung 112 zu der Steuerung 106 ausgegeben wird, wird mithilfe des Addierers 117 ein Korrekturwert aus dem Korrekturwertspeicher 116 zu dem Ausgangswert hinzu addiert. Der Korrekturwert kann sowohl positiv als auch negativ sein, sodass der Ausgangswert mittels des Korrekturwerts vergrößert oder verkleinert werden kann.

Zum Einstellen des Korrekturwerts in dem Korrekturwertspeicher 116 umfasst die Strommessvorrichtung 110 eine Kalibriersteuerung 118. Die Kalibriersteuerung 118 empfängt den Ausgangswert von der Wandlerschaltung 112, vorzugsweise als einen digitalen Ausgangswert.

Die Kalibriersteuerung 118 kann einen Schalter 119 der Strommessvorrichtung 110 ansteuern, um diesen wahlweise zu öffnen oder zu schließen. Dies wird in Fig. 1 schematisch mittels des gestrichelten Pfeils von der Kalibriersteuerung 118 zu dem Schalter 119 gezeigt. Der Schalter 119 kann beispielsweise einen Transistor umfassen, insbesondere einen Feldeffekttransistor (FET). Der Schalter 119 ist mit dem ersten Anschluss 113 und dem zweiten Anschluss 114 des Messwiderstand 111 derart gekoppelt, dass der Schalter 119 den Messwiderstand 111 im geschlossenen Zustand kurzschließt, d.h., dass im geschlossenen Zustand des Schalters 119 der erste Anschluss 113 über den Schalter 119 mit dem zweiten Anschluss 114 gekoppelt wird. Der Widerstand des Schalters 119 ist im geschlossenen Zustand viel kleiner als der Widerstand des Messwiderstands 111, sodass ein Spannungsabfall zwischen dem ersten Anschluss 113 und dem zweiten Anschluss 114 bei geschlossenem Schalter 119 im Wesentlichen Null beträgt. Der Widerstand des Schalters 119 ist im geschlossenen Zustand beispielsweise um den Faktor zehn oder 100 kleiner als der Widerstand des Messwiderstands 111.

Alternativ oder zusätzlich kann die Kalibriersteuerung 118 auf die Steuerung 106 einwirken, sodass die Steuerung 106 den Schalter 105 dauerhaft geöffnet hält.

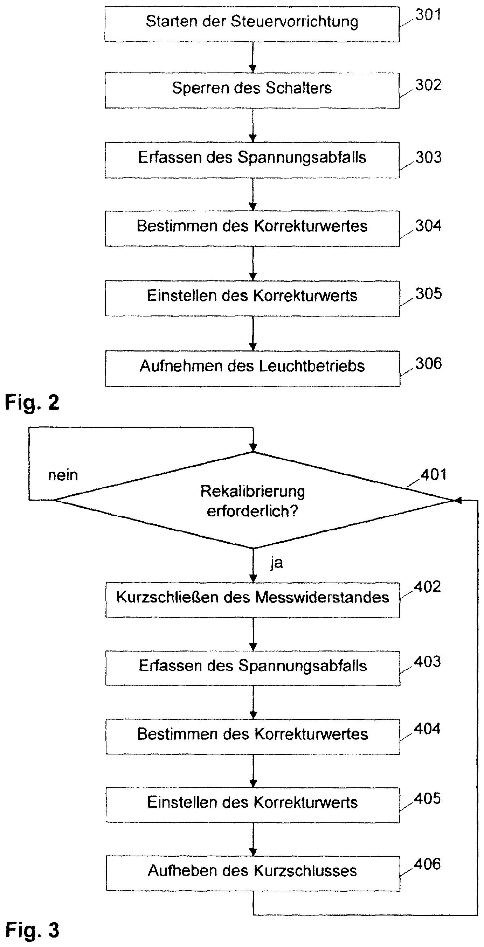

Die Arbeitsweise der Strommessvorrichtung 110 und insbesondere die Arbeitsweise der Kalibriersteuerung 118 wird nachfolgend unter Bezugnahme auf die Fig. 2 und 3 im Detail beschrieben werden. Unter Bezugnahme auf Fig. 2 wird eine Kalibrierung der Strommessvorrichtung 110 beim Starten der Steuervorrichtung 100 durchgeführt. Das Starten der Steuervorrichtung 100 ist ein Betrieb der Steuervorrichtung, wenn die Steuervorrichtung 100 ausgehend von einem stromlosen Zustand eingeschaltet wird, indem beispielsweise eine Spannung an den Eingang 101 und den Masseanschluss 102 angelegt wird. Unter Bezugnahme auf Fig. 3 wird eine Kalibrierung der Strommessvorrichtung im laufenden Betrieb der Steuervorrichtung 100 beschrieben, d.h., während ein von der Steuervorrichtung 100 bereitgestellter Strom durch das Leuchtmittel 200 fließt. Die beiden unter Bezugnahme auf die Fig. 2 und 3 beschriebenen Verfahren können unabhängig voneinander verwendet werden. Die beiden unter Bezugnahme auf die Fig. 2 und 3 beschriebenen Verfahren können auch kombiniert verwendet werden: Beispielsweise kann das Verfahren der Fig. 2 beim Einschalten der Steuervorrichtung 100 durchgeführt werden und danach kann das Verfahren der Fig. 3 im laufenden Betrieb der Steuervorrichtung 100 durchgeführt werden. Wenn nur die Kalibrierung mit dem Verfahren der Fig. 2 durchgeführt wird, ist der Schalter 119 nicht erforderlich und kann ersatzlos entfallen.

In Fig. 2 wird im Schritt 301 die Steuervorrichtung 100 gestartet. Die Steuervorrichtung 100 kann beispielsweise gestartet werden, indem eine Versorgungsspannung an den Eingang 101 und den Masseanschluss 102 angelegt wird. Alternativ oder zusätzlich kann die Steuervorrichtung 100 mittels eines Steuerbefehls an die Steuerung 106 gestartet werden. Die Strommessvorrichtung 110 ermittelt ebenfalls das Starten der Steuervorrichtung 100, beispielsweise sobald die Strommessvorrichtung 110 mit der Versorgungsspannung versorgt wird oder mittels eines Signals von beispielsweise der Steuerung 106. Sobald die Strommessvorrichtung 110 das Starten der Steuervorrichtung 100 festgestellt hat, gibt die Strommessvorrichtung 110 im Schritt 302 ein Signal an die Steuerung 106, welches der Steuerung 106 anzeigt, den Schalter 105 zu sperren. Dadurch fließt zunächst kein Strom durch das Leuchtmittel 200 und den Messwiderstand 111.

Im Schritt 303 erfasst die Wandlerschaltung 112 einen Spannungsabfall über dem Messwiderstand 111. Da der Strom durch den Messwiderstand 111 Null ist, ist theoretisch der Spannungsabfall über dem Messwiderstand 111 ebenfalls Null und die Wandlerschaltung 112 gibt theoretisch an ihrem Ausgang 115 einen Ausgangswert aus, welcher einem Spannungswert von Null entspricht. In der Praxis treten jedoch Abweichungen auf, welche durch Bauteiltoleranzen der Wandlerschaltung 111 bedingt sind. Diese Bauteiltoleranzen können ferner durch Temperaturänderungen oder Alterung im Betrieb veränderlich sein. Der von der Wandlerschaltung 112 aktuell ausgegebene Ausgangswert an dem Ausgang 115 wird daher von der Kalibriersteuerung 118 verwendet, um im Schritt 304 einen Korrekturwert zu bestimmen. Der Korrekturwert kann beispielsweise derart bestimmt werden, dass eine Summe aus dem Ausgangswert am Ausgang 115 und dem Korrekturwert den gewünschten Wert Null ergibt. Der Korrekturwert wird im Schritt 305 in dem Korrekturwertspeicher 116 eingestellt. Am Ausgang des Addierers 117 ergibt sich daher in diesem Zustand der Steuervorrichtung 100 ein Wert, welcher einem Spannungsabfall von Null bzw. einem Strom von Null entspricht. Somit ist die Strommessvorrichtung 110 kalibriert. Dies kann die Strommessvorrichtung 110 der Steuerung 106 anzeigen und die Steuerung 106 kann im Schritt 306 ihren Betrieb aufnehmen und den Schalter 105 ansteuern, um das Leuchtmittel 200 mit Energie zu versorgen.

Wie bereits zuvor erwähnt, kann durch Temperaturänderung oder Bauteilalterung einer erneute Kalibrierung der Strommessvorrichtung 110 im laufenden Betrieb der Steuervorrichtung 100 erforderlich oder zumindest vorteilhaft sein.

In der Fig. 3 bestimmt die Kalibriersteuerung 118 daher im Schritt 401, ob eine Kalibrierung oder Rekalibrierung der Strommessvorrichtung 110 erforderlich ist. Grundlage dafür kann beispielsweise ein Timer, beispielsweise ein Betriebsstundenzähler, sein, welcher eine periodische Rekalibrierung anstößt. Ferner können auch Spannungsschwankungen der Versorgungsspannung im Betrieb oder einer geänderten Leuchtstärkeeinstellung des Leuchtmittels 200 in beispielsweise einem Dimm-Betrieb der Steuervorrichtung 100 als Auslöser für eine Rekalibrierung verwendet werden.

Wenn die Kalibriersteuerung 118 im Schritt 401 bestimmt hat, dass eine Rekalibrierung durch geführt werden soll, steuert die Kalibriersteuerung 118 im Schritt 402 den Schalter 119 an, um den Schalter 119 zu schließen und somit den Messwiderstand 111 kurzzuschließen. Der Spannungsabfall über dem Messwiderstand 111 beträgt somit in diesem Zustand im Wesentlichen Null.

Im Schritt 403 wird der Spannungsabfall über dem Messwiderstand 111 von der Wandlerschaltung 112 erfasst. Wie zuvor beschrieben, zeigt die Wandlerschaltung 112 in diesem Fall nur theoretisch an ihrem Ausgang 115 einen dem Spannungsabfall Null entsprechenden Ausgangswert an. Der von der Wandlerschaltung 112 tatsächlich ausgegebene Ausgangswert an dem Ausgang 115 wird von der Kalibriersteuerung 118 verwendet, um im Schritt 404 einen Korrekturwert zu bestimmen. Der Korrekturwert wird im Schritt 405 in dem Korrekturwert Speicher 116 eingestellt. Damit ist die Strommessvorrichtung 110 rekalibriert. Im Schritt 406 steuert die Kalibriersteuerung 118 den Schalter 119 derart an, dass der Schalter 119 geöffnet wird und somit wieder der durch das Leuchtmittel 200 fließende Strom gemessen werden kann.

Während der Schalter 119 geschlossen ist, ist selbstverständlich keine korrekte Strommessung des Stroms durch das Leuchtmittel 200 möglich. Dies kann die Kalibriersteuerung 118 der Steuerung 106 anzeigen und die Steuerung 106 kann in dieser Zeit den Schalter 105 ohne rückgekoppelte Regelung über die Strommessung ansteuern. Da die Rekalibrierung jedoch nur verhältnismäßig wenig Zeit in Anspruch nimmt, ist die Zeit, in welcher das Leuchtmittel 200 ungeregelt angesteuert wird, verhältnismäßig kurz.

Auf der Grundlage der kalibrierten Strommessung kann die Steuerung 106 den Strom durch das Leuchtmittel 200 genau regeln.

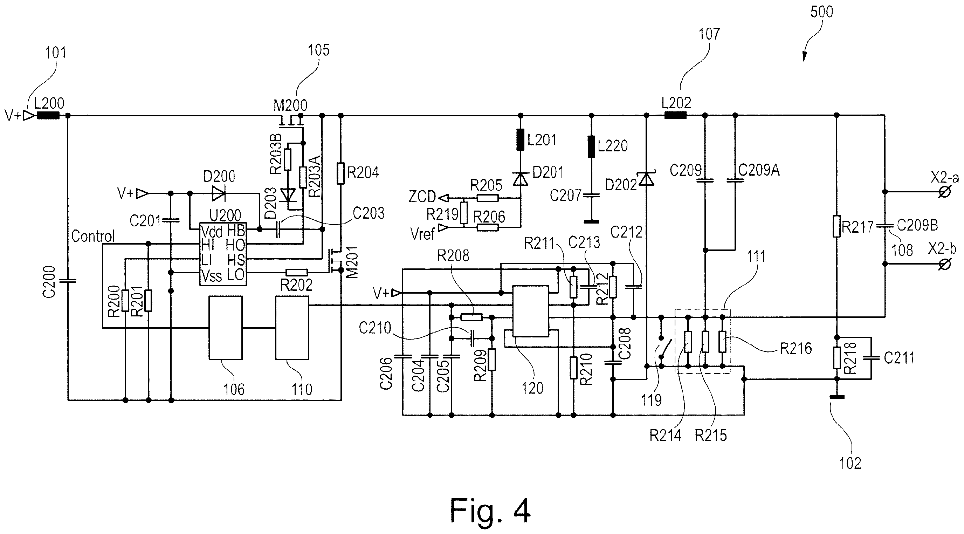

Fig. 4 zeigt eine weitere Ausführungsform einer Steuervorrichtung 500 zum Betreiben eines LED-Leuchtmittels. Die Steuervorrichtung 500 umfasst die im Zusammenhang mit der Fig. 1 beschriebenen Komponenten des Abwärtswandlers und die Strommessvorrichtung 110. Der Schalter 119, der Messwiderstand 111 sowie eine Verstärkerschaltung der Wandlerschaltung 112 sind aus Gründen der Übersichtlichkeit außerhalb der Strommessvorrichtung 110 gezeigt, gehören jedoch, wie in Verbindung mit der Fig. 1 beschrieben, zu der Strommessvorrichtung 110. Der Schalter 105 ist in der Ausführungsform der Fig. 4 als ein MOSFET ausgebildet. Der Schalter 119 kann, kann ebenfalls als ein am MOSFET ausgebildet sein. Zur Erfassung des Spannungsabfalls über dem Messwiderstand 111, welcher in der Fig. 4 drei parallelgeschaltete Widerstände R214, R215 und R216 umfasst, umfasst die Strommessvorrichtung 110 eine Verstärkerschaltung, welche beispielsweise einen Operationsverstärker 120 umfasst. Die Ausgabe des Operationsverstärkers 120 wird der Wandlerschaltung der Strommessvorrichtung 110 zugeführt. Bei der Kalibrierung der Strommessvorrichtung 110 werden somit auch Toleranzen und temperatur- und alterungsbedingte Änderungen von Komponenten der Verstärkerschaltung berücksichtigt und über den Korrekturwert ausgeglichen.

Die Arbeitsweise der Steuervorrichtung 500 entspricht im Wesentlichen der Arbeitsweise der Steuervorrichtung 100 der Fig. 1. Die in Fig. 4 gezeigten zusätzlichen Komponenten dienen im Wesentlichen einer zuverlässigen Ansteuerung des Schalters 105 mithilfe des integrierten Schaltkreises U200, sowie der Erzeugung von benötigten Hilfsspannungen und einem definierten Hochfahren der gesamten Schaltung nach einem Anlegen an eine Versorgungsspannung.

Es ist klar, dass bei den vorangegangenen Beispielen vielfältige Modifikationen möglich sind. Beispielsweise können als Leuchtmittel 200 mehrere in Reihe und/oder parallel geschaltete einzelne Leuchtdioden verwendet werden. Weiterhin kann die zuvor beschriebene Steuervorrichtung auch in Kombination mit mehreren verschiedenen Arten anderer elektrischer Lasten genutzt werden, zum Beispiel in Verbindung mit einem Lüfter oder einem Elektromotor zur Bewegung des LED-Leuchtmittels. Es ist klar, dass die anhand von Fig. 1 erläuterte Implementierung eines Abwärtswandlers aus Gründen der Veranschaulichung vereinfachend dargestellt ist und in praktischen Implementierungen auf vielfältige Weise ergänzt oder modifiziert werden kann, wie es beispielsweise in Fig. 4 dargestellt ist. Ferner kann die Steuervorrichtung zumindest teilweise in das zu versorgende LED-Leuchtmittel integriert sein.

## Patentansprüche

1. Verfahren zum Kalibrieren einer Strommessvorrichtung einer Steuervorrichtung für ein Leuchtmittel, wobei die Strommessvorrichtung (110) Messmittel (111) umfasst, welche im Betrieb der Steuervorrichtung (100, 500) mit dem Leuchtmittel (200) gekoppelt sind, wobei die Messmittel (111) im Betrieb der Steuervorrichtung (100, 500) in Reihe mit dem Leuchtmittel (200) geschaltet sind, wobei das Verfahren umfasst:
- automatisches Einstellen eines vorgegeben Stroms der Größe Null durch die Messmittel (111) im Betrieb der Steuervorrichtung (100, 500),
- automatisches Erfassen einer elektrischen Größe an den Messmitteln (111), während der vorgegebene Strom eingestellt ist, wobei die elektrische Größe ein Spannungsabfall über den Messmitteln (111) ist, und
- automatisches Bestimmen eines Korrekturwerts für die Strommessvorrichtung (110) in Abhängigkeit von der erfassten elektrischen Größe,
**dadurch gekennzeichnet, dass**
die Messmittel (111) einen Messwiderstand umfassen, durch welchen, wenn im Betrieb der Steuervorrichtung nicht der vorgegebene Strom durch die Messmittel eingestellt ist, der Strom durch den Messwiderstand zumindest im Mittel gleich dem Strom durch das Leuchtmittel ist.

2. Verfahren nach Anspruch 1, wobei das Einstellen des vorgegeben Stroms durch die Messmittel (111) im Betrieb der Steuervorrichtung (100, 500) umfasst:
- Verhindern eines Stromflusses durch die Messmittel (111) im Betrieb der Steuervorrichtung (100, 500).

3. Verfahren nach einem der vorhergehenden Ansprüche, wobei das Einstellen des vorgegeben Stroms durch die Messmittel (111) im Betrieb der Steuervorrichtung (100, 500) umfasst:
- Verbinden eines ersten Anschlusses (113) der Messmittel (111) mit einem zweiten Anschluss (114) der Messmittel (111) mittels eines von der Strommessvorrichtung (110) steuerbaren Schalters (119).

4. Verfahren nach Anspruch 3, wobei der Schalter (119) einen Feldeffekttransistor umfasst.

5. Verfahren nach einem der vorhergehenden Ansprüche, wobei die Steuervorrichtung (100, 500) eine Schaltvorrichtung (105) zum Steuern eines Stroms durch das Leuchtmittel (200) umfasst, wobei das Einstellen des vorgegeben Stroms durch die Messmittel (111) im Betrieb der Steuervorrichtung (100, 500) umfasst:
- Sperren der Schaltvorrichtung (105) während einer Startphase der Steuervorrichtung (100, 500) bis der Schritt des Erfassens der elektrischen Größe an den Messmitteln (111) abgeschlossen ist.

6. Verfahren nach einem der vorhergehenden Ansprüche, wobei das Leuchtmittel (200) mindestens eine Leuchtdiode umfasst.

7. Strommessvorrichtung für eine Steuervorrichtung für ein Leuchtmittel, umfassend:
- Messmittel (111), welche im Betrieb der Steuervorrichtung (100, 500) mit dem Leuchtmittel (200) gekoppelt sind, wobei die Messmittel (111) im Betrieb der Steuervorrichtung (100, 500) in Reihe mit dem Leuchtmittel (200) geschaltet sind,
- eine Wandlerschaltung (112), welche mit den Messmitteln (111) gekoppelt ist, wobei die Wandlerschaltung (112) ausgestaltet ist, eine elektrische Größe an den Messmitteln (111) zu erfassen, wobei die elektrische Größe ein Spannungsabfall über den Messmitteln (111) ist, und
- eine Kalibriersteuerung (118), welche ausgestaltet ist,
einen vorgegeben Strom der Größe Null durch die Messmittel (111) im Betrieb der Steuervorrichtung (100, 500) einzustellen,
mittels der Wandlerschaltung (112) die elektrische Größe an den Messmitteln (111) zu ermitteln, während der vorgegebene Strom eingestellt ist, und
einen Korrekturwert für die Strommessvorrichtung (110) in Abhängigkeit von der elektrischen Größe zu bestimmen,
**dadurch gekennzeichnet, dass**
die Messmittel (111) einen Messwiderstand umfassen, durch welchen, wenn im Betrieb der Steuervorrichtung nicht der vorgegebene Strom durch die Messmittel eingestellt ist, der Strom durch den Messwiderstand zumindest im Mittel gleich dem Strom durch das Leuchtmittel ist.

8. Strommessvorrichtung nach Anspruch 7, wobei die Strommessvorrichtung (110) zur Durchführung des Verfahrens nach einem der Ansprüche 1-8 ausgestaltet ist.

9. Dimmschaltung für eine Leuchtdiode (200), umfassend die Strommessvorrichtung (110) nach Anspruch 7 oder Anspruch 8.

## Claims

1. Method for calibrating a current measuring device of a control device for a luminaire, the current measuring device (110) comprising measuring means (111) which are coupled to the luminaire (200) during operation of the control device (100, 500), the measuring means (111) being connected in series with the luminaire (200) during operation of the control device (100, 500), the method comprising:
- automatically setting a predetermined current of zero magnitude through the measuring means (111) during operation of the control device (100, 500),
- automatically detecting an electrical variable at the measuring means (111) while the predetermined current is set, the electrical variable being a voltage drop across the measuring means (111), and
- automatically determining a correction value for the current measuring device (110) depending on the detected electrical variable,
**characterized in that**
the measuring means (111) comprise a measuring resistor, by means of which, when the predetermined current is not set through the measuring means during operation of the control device, the current through the measuring resistor is at least on average equal to the current through the luminaire.

2. Method according to claim 1, wherein setting the predetermined current through the measuring means (111) during operation of the control device (100, 500) comprises:
- preventing a current flow through the measuring means (111) during operation of the control device (100, 500).

3. Method according to any of the preceding claims, wherein setting the predetermined current through the measuring means (111) during operation of the control device (100, 500) comprises:
- connecting a first terminal (113) of the measuring means (111) to a second terminal (114) of the measuring means (111) by means of a switch (119) controllable by the current measuring device (110).

4. Method according to claim 3, wherein the switch (119) comprises a field effect transistor.

5. Method according to any of the preceding claims, wherein the control device (100, 500) comprises a switching device (105) for controlling a current through the luminaire (200), wherein setting the predetermined current through the measuring means (111) during operation of the control device (100, 500) comprises:
- locking the switching device (105) during a start phase of the control device (100, 500) until the step of detecting the electrical variable at the measuring means (111) is complete.

6. Method according to any of the preceding claims, wherein the luminaire (200) comprises at least one light-emitting diode.

7. Current measuring device for a control device for a luminaire, comprising:
- measuring means (111), which are coupled to the luminaire (200) during operation of the control device (100, 500), the measuring means (111) being connected in series with the luminaire (200) during operation of the control device (100, 500),
- a converter circuit (112), which is coupled to the measuring means (111), the converter circuit (112) being designed to detect an electrical variable at the measuring means (111), the electrical variable being a voltage drop across the measuring means (111), and
- a calibration controller (118), which is designed to
set a predetermined current of zero magnitude through the measuring means (111) during operation of the control device (100, 500),
ascertain the electrical variable at the measuring means (111) by means of the converter circuit (112), while the predetermined current is set, and
determine a correction value for the current measuring device (110) depending on the electrical variable,
**characterized in that**
the measuring means (111) comprise a measuring resistor, by means of which, when the predetermined current is not set through the measuring means during operation of the control device, the current through the measuring resistor is at least on average equal to the current through the luminaire.

8. Current measuring device according to claim 7, wherein the current measuring device (110) is designed to carry out the method according to any of claims 1-8.

9. Dimming circuit for a light-emitting diode (200), comprising the current measuring device (110) according to claim 7 or claim 8.

## Revendications

1. Procédé pour l'étalonnage d'un dispositif de mesure du courant d'un dispositif de commande pour un moyen d'éclairage, le dispositif de mesure du courant (110) comprenant des moyens de mesure (111) qui sont couplés au moyen d'éclairage (200) lors du fonctionnement du dispositif de commande (100, 500), les moyens de mesure (111) étant commutés en série avec le moyen d'éclairage (200) lors du fonctionnement du dispositif de commande (100, 500), le procédé comprenant :
- le réglage automatique d'un courant spécifié de grandeur zéro à travers les moyens de mesure (111) lors du fonctionnement du dispositif de commande (100, 500),
- la détection automatique d'une grandeur électrique au niveau des moyens de mesure (111), pendant que le courant spécifié est réglé, la grandeur électrique étant une chute de tension sur les moyens de mesure (111) et
- la détermination automatique d'une valeur de correction pour le dispositif de mesure du courant (110) en fonction de la grandeur électrique détectée,
**caractérisé en ce que**
les moyens de mesure (111) comprennent une résistance de mesure à travers laquelle, lorsque lors du fonctionnement du dispositif de commande le courant spécifié n'est pas réglé à travers les moyens de mesure, le courant à travers la résistance de mesure est au moins en moyenne identique au courant à travers le moyen d'éclairage.

2. Procédé selon la revendication 1, le réglage du courant spécifié à travers les moyens de mesure (111) lors du fonctionnement du dispositif de commande (100, 500) comprenant :
- l'empêchement d'un flux de courant à travers les moyens de mesure (111) lors du fonctionnement du dispositif de commande (100, 500).

3. Procédé selon l'une des revendications précédentes, le réglage du courant spécifié à travers les moyens de mesure (111) lors du fonctionnement du dispositif de commande (100, 500) comprenant :
- la connexion d'un premier connecteur (113) des moyens de mesure (111) à un deuxième connecteur (114) des moyens de mesure (111) à l'aide d'un commutateur (119) pouvant être commandé par le dispositif de mesure du courant (110).

4. Procédé selon la revendication 3, le commutateur (119) comprenant un transistor à effet de champ.

5. Procédé selon l'une des revendications précédentes, le dispositif de commande (100, 500) comprenant un dispositif de commutation (105) pour la commande d'un courant à travers le moyen d'éclairage (200), le réglage du courant spécifié à travers les moyens de mesure (111) lors du fonctionnement du dispositif de commande (100, 500) comprenant :
- le blocage du dispositif de commutation (105) pendant une phase de démarrage du dispositif de commande (100, 500) jusqu'à ce que l'étape de détection de la grandeur électrique au niveau des moyens de mesure (111) soit terminée.

6. Procédé selon l'une des revendications précédentes, le moyen d'éclairage (200) comprenant au moins une diode électroluminescente.

7. Dispositif de mesure du courant pour un dispositif de commande pour un moyen d'éclairage, comprenant :
- des moyens de mesure (111), qui sont couplés au moyen d'éclairage (200) lors du fonctionnement du dispositif de commande (100, 500), les moyens de mesure (111) étant commutés en série avec le moyen d'éclairage (200) lors du fonctionnement du dispositif de commande (100, 500),
- un circuit convertisseur (112), qui est couplé aux moyens de mesure (111), le circuit convertisseur (112) étant conçu pour détecter une grandeur électrique au niveau des moyens de mesure (111), la grandeur électrique étant une chute de tension sur les moyens de mesure (111) et
- une commande d'étalonnage (118), qui est conçue
pour régler un courant spécifié de grandeur zéro à travers les moyens de mesure (111) lors du fonctionnement du dispositif de commande (100, 500),
pour établir, à l'aide du circuit convertisseur (112), la grandeur électrique au niveau des moyens de mesure (111) pendant que le courant spécifié est réglé et
pour déterminer une valeur de correction pour le dispositif de mesure du courant (110) en fonction de la grandeur électrique, **caractérisé en ce que**
les moyens de mesure (111) comprennent une résistance de mesure à travers laquelle, lorsque lors du fonctionnement du dispositif de commande le courant spécifié n'est pas réglé à travers les moyens de mesure, le courant à travers la résistance de mesure est au moins en moyenne identique au courant à travers le moyen d'éclairage.

8. Dispositif de mesure du courant selon la revendication 7, le dispositif de mesure du courant (110) étant conçu pour l'exécution du procédé selon l'une des revendications 1 à 8.

9. Commutation de tamisage pour une diode électroluminescente (200), comprenant le dispositif de mesure du courant (110) selon la revendication 7 ou la revendication 8.
